# FASCICULE DE BREVET EUROPEEN

(11) **EP 2 566 996 B1**
(45) Date de publication et mention de la délivrance du brevet: **19.02.2014**
(21) Numéro de dépôt: 11730358.6
(22) Date de dépôt: 08.04.2011
(51) Int. Cl.: C23C 2/40, B05C 3/12, C30B 15/00, H01L 31/18, B05C 5/02, B05C 9/04, C30B 29/06

(54) **RUBAN DE CARBONE DESTINÉ À RECEVOIR UNE COUCHE D'UN MATÉRIAU SEMI-CONDUCTEUR**
KOHLENSTOFFBAND ZUR AUFNAHME EINER HALBLEITERMATERIALSCHICHT
CARBON TAPE INTENDED TO RECEIVE A LAYER OF A SEMICONDUCTOR MATERIAL

(30) Priorité: 04.05.2010 FR 1053439
(43) Date de publication de la demande: 13.03.2013
(73) Titulaire: Solarforce, 38300 Bourgoin Jallieu (FR)
(72) Inventeur: TASTEVIN, Robert, F-38080 Saint Marcel Bel Accueil (FR)
(74) Mandataire: Peguet, Wilfried
(86) Numéro de dépôt international: PCT/FR2011/050808
(87) Numéro de publication internationale: WO 2011/138532

(56) Documents cités:
- FR-A1- 2 887 262

## Description

La présente invention se rapporte à un ruban de carbone destiné à recevoir une couche d'un matériau semi-conducteur sur au moins l'une de ses faces, un procédé de mise en forme dudit ruban de carbone ainsi qu'un procédé pour déposer une couche d'un matériau semi-conducteur sur au moins l'une des faces du ruban de carbone.

Les cellules photovoltaïques comportent des plaques minces d'un matériau semi-conducteur, le plus utilisé étant actuellement le silicium polycristallin.

L'invention s'appliquant tout particulièrement au tirage de rubans de silicium destinés à la fabrication de cellules photovoltaïques, l'exposé qui suit fait donc référence au silicium, étant entendu que l'invention s'applique également à d'autres matériaux semi-conducteurs tels que le germanium et les composés semi-conducteurs de type III-V de la famille GaAs à fusion congruente ou quasi-congruente. Les plaques de silicium sont obtenues de préférence à partir d'une couche de silicium, formant un film, déposée sur un substrat en carbone par tirage de ce substrat à travers un bain de silicium fondu. Le substrat a la forme d'un ruban.

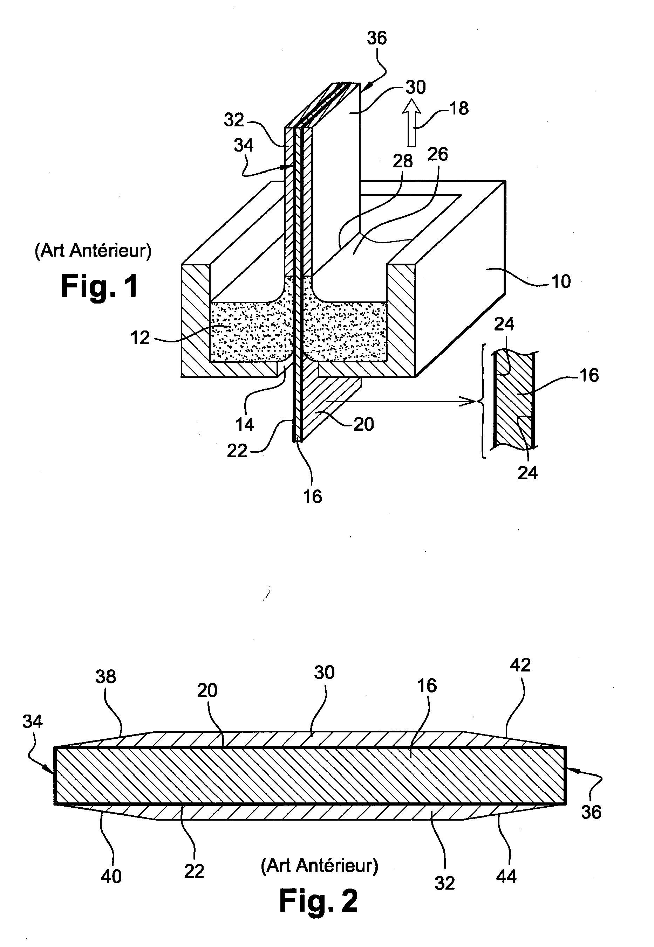

La figure 1 illustre de façon générale le procédé de l'art antérieur, désigné par procédé RST (pour Ruban sur Substrat Temporaire). Un creuset 10, équipé de moyens de chauffage (non représentés), contient un bain 12 de silicium fondu, sous forme liquide. Le fond du creuset est muni d'une fente 14. A l'aide de moyens de tirage non représentés, un ruban de carbone 16 de faible épaisseur (de l'ordre de 200 à 350 µm) est tiré sensiblement verticalement, de bas en haut dans le sens de la flèche 18, dans le bain 12 de silicium à vitesse sensiblement constante. Les deux faces 20 et 22 du ruban ont initialement été recouvertes d'une couche de carbone pyrolytique 24 de faible épaisseur (environ 1 à 5 µm). Le silicium fondu mouille les deux faces 20 et 22 du ruban et un ménisque 26 de silicium liquide se forme sur chaque face du ruban avec une ligne de raccordement solide-liquide 28 située à environ 6,8 mm de la surface du bain dans la partie centrale du ruban. Une couche mince de silicium 30-32 se forme alors sur chacune des deux faces 20 et 22 du ruban de carbone. La forme et les dimensions de la fente 14 sont adaptées, d'une part pour laisser pénétrer le ruban de carbone 16 dans le creuset et, d'autre part, pour éviter que du silicium fondu ne s'écoule à travers la fente. Bien qu'il soit avantageux d'obtenir simultanément deux films de silicium 30 et 32, un film par face du ruban, on peut concevoir de n'obtenir qu'un seul film en empêchant le dépôt de silicium sur l'une des deux faces.

Le procédé RST est par exemple décrit dans les brevets FR 2 386 359 et 2 561 139.

Ce procédé de tirage est cependant confronté au problème de l'instabilité du ménisque de silicium liquide à proximité de chaque extrémité longitudinale (bord) 34-36 du ruban de carbone 16. On a en effet constaté que la ligne de raccordement solide-liquide 28 tend à s'abaisser d'environ 6,8 mm à typiquement 2 à 4 mm par rapport à la surface du bain de silicium sur les extrémités longitudinales du ruban, sur une largeur d'environ 5 mm à partir de chaque extrémité longitudinale. Il en résulte que l'épaisseur de la couche de silicium 30 ou 32 déposée sur chaque face du ruban de carbone diminue vers les extrémités longitudinales 34 et 36 jusqu'à atteindre une valeur pratiquement nulle.

La figure 2 illustre schématiquement l'amincissement progressif sur les extrémités longitudinales des couches de semi-conducteur obtenues par le procédé de l'art antérieur représenté sur la figure 1. La section du ruban de carbone 16, représenté en coupe transversale et sans les couches 24 de carbone pyrolytique (ou pyrocarbone), a sensiblement une forme rectangulaire. Les deux couches de semi-conducteur 30 et 32 ont été déposées simultanément sur les deux faces respectivement 20 et 22 du ruban. Dans les zones 38-40 et 42-44 adjacentes aux deux extrémités longitudinales respectivement 34 et 36 du ruban, l'épaisseur des couches diminue progressivement, sur une distance typiquement de l'ordre de 5 mm. Les films de semi-conducteur ainsi fabriqués sont donc particulièrement fragiles sur les bords. De plus, il apparaît une nucléation de grains de petites dimensions qui se propagent dans les parties latérales du film, ce qui a pour effet de diminuer les performances photovoltaïques du film de silicium.

Des solutions à ce problème ont été proposées dans les brevets FR 2 568 490 et 2 550 965. Ces solutions consistent à relever le niveau de la ligne solide-liquide sur les extrémités longitudinales du ruban de carbone à l'aide de moyens extérieurs placés à proximité des extrémités longitudinales du ruban. Ainsi, le premier brevet cité fait appel à des plaquettes élevant localement par capillarité le niveau du bain de silicium fondu et le deuxième brevet cité propose de placer une goulotte en regard de chaque bord du ruban de silicium, également pour élever localement le niveau du bain de silicium fondu. Ces solutions compliquent la fabrication du bâti de tirage et l'opération de tirage elle-même.

Une autre solution a été apportée par le document FR 2 887 262, qui ne fait pas appel à des moyens extérieurs. Elle consiste à adapter la forme des extrémités longitudinales du ruban de carbone utilisées comme support temporaire des couches de semi-conducteur, de façon à augmenter l'épaisseur des couches de semi-conducteur déposé sur les extrémités longitudinales. Les extrémités longitudinales du ruban de carbone sont mises en forme par repoussage en continu à l'aide de moyens mécaniques afin de former des becquets.

Une fois les extrémités longitudinales ainsi formées, le ruban de carbone est classiquement enroulé sur lui-même autour d'un support de type bobine, pour pouvoir être utilisé facilement lors d'étapes ultérieures telles que le dépôt d'une couche de carbone pyrolytique ou le tirage du ruban à travers le bain du matériau semi-conducteur fondu.

Plus particulièrement, cet enroulement est effectué simultanément avec un film d'insert récupérable, ce film d'insert étant indispensable pour ne pas écraser le becquet au cours de l'enroulement. Lors du déroulement du ruban de carbone, le film d'insert doit ensuite être séparé du ruban de carbone et récupéré pour une nouvelle utilisation.

On peut noter par exemple qu'il est nécessaire de prévoir le co-enroulement du ruban de carbone avec ledit film d'insert pour sa mise en place sur une bobine, la récupération du film d'insert avant l'étape de dépôt du carbone pyrolytique sur le ruban de carbone, le co-enroulement du film d'insert après l'étape de dépôt du carbone pyrolytique, ou la récupération de l'insert avant l'étape de dépôt du matériau semi-conducteur.

Toutefois, chacune de ces opérations en présence du film d'insert, rend les séquences d'enroulement et de déroulement du ruban de carbone plus complexes en réalisation et nécessite la gestion de nombreux paramètres.

Le but de la présente invention est de pallier les inconvénients des techniques de l'art antérieur en proposant notamment un ruban de carbone permettant de fabriquer une couche d'un matériau semi-conducteur non fragilisée sur les extrémités longitudinales du ruban de carbone, tout en facilitant les opérations d'enroulement et de déroulement du ruban de carbone.

La présente invention a pour objet un ruban de carbone comportant deux faces (longitudinales) et deux extrémités longitudinales, au moins l'une des faces du ruban comprenant une partie centrale située entre les deux extrémités longitudinales et destinée à recevoir le dépôt d'une couche d'un matériau semi-conducteur, caractérisé en ce qu'il comporte en outre, sur au moins l'une de ses faces, au moins une rainure longitudinale située entre l'une desdites extrémités et la partie centrale, et en ce que la rainure longitudinale est conformée de sorte que, lorsque la couche dudit matériau semi-conducteur est déposée, le matériau semi-conducteur remplissant ladite rainure forme une protubérance adjacente à l'une des extrémités longitudinales de l'une des faces du ruban de carbone.

Ainsi, la ou les rainures longitudinales du ruban de carbone selon l'invention permettent avantageusement de modifier la forme de la surface de mouillage du matériau semi-conducteur fondu une fois la ou les rainures remplies dudit matériau, dans le but d'augmenter l'épaisseur de la couche de matériau semi-conducteur à ses extrémités. De ce fait, ladite couche de matériau semi-conducteur a une épaisseur sensiblement constante sur toute sa surface, y compris à ces extrémités.

Plus particulièrement, ladite rainure longitudinale peut être composée avantageusement d'une portion formant le fond de la rainure entourée par deux portions sensiblement rectilignes inclinées par rapport à la face du ruban de carbone comprenant ladite rainure. Plus particulièrement, la portion formant le fond de la rainure peut être courbe ou sensiblement rectiligne.

Selon un mode de réalisation particulier, le ruban de carbone comporte, sur au moins l'une de ses faces, deux rainures longitudinales situées entre les deux extrémités longitudinales du ruban.

Selon un autre mode de réalisation particulier, le ruban de carbone comporte, sur chacune de ses faces, au moins une rainure longitudinale située entre les deux extrémités longitudinales du ruban.

Selon un mode préféré de réalisation, le ruban de carbone comporte, sur chacune de ses faces, deux rainures longitudinales situées entre les deux extrémités longitudinales du ruban.

Plus particulièrement, chacune des faces du ruban de carbone comporte une partie longitudinale au niveau de chaque extrémité longitudinale, cette partie longitudinale n'étant de préférence pas destinée à recevoir le dépôt d'une couche d'un matériau semi-conducteur.

Plus particulièrement, lorsque le ruban de carbone comporte deux rainures longitudinales sur chacune de ses faces, les extrémités longitudinales du ruban de carbone ne sont ainsi pas destinées à recevoir le dépôt d'une couche d'un matériau semi-conducteur.

Selon un mode de réalisation particulier, en section transversale, l'épaisseur au niveau des extrémités longitudinales du ruban de carbone ainsi que l'épaisseur au niveau de ses parties centrales sont supérieures à ou aux épaisseurs au niveau de la ou des rainures longitudinales.

En outre, les épaisseurs du ruban de carbone respectivement au niveau de ses extrémités longitudinales ainsi qu'au niveau de ses parties centrales sont sensiblement identiques. Ainsi, au moins l'une des parties longitudinales et la partie centrale d'une même face sont dans le même plan.

Cette caractéristique permet de partir d'un ruban de carbone plan composé de deux surfaces planes et continues qui vont subir un formage pour créer la ou les rainures longitudinales dans l'épaisseur dudit ruban.

Cela signifie que l'épaisseur du ruban de carbone de l'invention, en coupe transversale, est sensiblement identique sur toute sa largueur, notamment au niveau de ses extrémités longitudinales et au niveau de ses parties centrales, excepté au niveau de la ou des rainures longitudinales.

La partie centrale d'au moins une des faces du ruban de carbone selon l'invention peut être de préférence sensiblement plane, exempte de toute texturation.

Le ruban de carbone de l'invention peut avoir une épaisseur donnée (e0) pouvant aller de 200 à 350 µm, et de préférence une épaisseur donnée de 250 µm. Cette épaisseur donnée (e0) est bien entendu supérieure à l'épaisseur (e1) du ruban de carbone au niveau du ou des rainures longitudinales.

Selon une forme de réalisation, les deux portions rectilignes sensiblement inclinées de la rainure longitudinale sont reliées respectivement à l'une des parties longitudinales et à la partie centrale du ruban par des zones courbes.

Selon une autre forme de réalisation, les deux portions rectilignes sensiblement inclinées de la rainure longitudinale sont reliées à la portion formant le fond de la rainure par des zones courbes.

Ces deux formes de réalisation peuvent être combinées.

De préférence, la portion formant le fond de la rainure, lorsqu'elle est sensiblement rectiligne, peut être sensiblement parallèle à l'une des faces du ruban de carbone.

Pour caractériser plus particulièrement la rainure longitudinale, et l'inclinaison de ses portions sensiblement rectilignes, des angles sont définis ci-après, ces angles permettent d'optimiser l'angle de mouillage du matériau semi-conducteur à proximité de l'extrémité longitudinale où la rainure longitudinale est située, afin d'augmenter l'épaisseur à l'extrémité de la couche de matériau semi-conducteur.

Selon une première réalisation, en section transversale, l'angle α1, formé entre la partie longitudinale et la portion sensiblement rectiligne inclinée (par rapport à la face du ruban de carbone comprenant ladite rainure) la plus proche de l'extrémité longitudinale, est défini tel que 90°< α1 < 180°, de préférence tel que 120°< α1 < 160°.

L'angle α1 permet avantageusement d'optimiser l'augmentation de l'épaisseur de la couche de matériau semi-conducteur. Pour cette raison, il doit être de préférence différent de 90° et plus grand que 90°.

Selon une seconde réalisation, en section transversale, l'angle β1, formé entre la partie centrale du ruban et la portion sensiblement rectiligne inclinée (par rapport à la face du ruban de carbone comprenant ladite rainure) la plus proche de la partie centrale, est défini tel que 90° < β1 < 180°, de préférence 120° < β1 < 160°.

L'angle β1 doit être de préférence différent de 90° et plus grand que 90° afin d'éviter la fragilité du matériau semi-conducteur entre la partie centrale et la portion sensiblement rectiligne inclinée la plus proche de la partie centrale.

Selon une troisième réalisation, lorsque la portion formant le fond de la rainure est sensiblement rectiligne, en section transversale, l'angle α2, formé entre la portion sensiblement rectiligne inclinée (par rapport à la face du ruban de carbone comprenant ladite rainure) la plus proche de l'extrémité longitudinale et la portion sensiblement rectiligne formant le fond de la rainure, est défini tel que 90°< α2 < 180°, de préférence tel que 120° < α2 < 160°.

Selon une quatrième réalisation, lorsque la portion formant le fond de la rainure est sensiblement rectiligne, en section transversale, l'angle β2, formé entre la portion rectiligne inclinée (par rapport à la face du ruban de carbone comprenant ladite rainure) la plus proche de la partie centrale et la portion sensiblement rectiligne formant le fond de la rainure, est défini tel que 90° < β2 < 180°, de préférence 120° < β2 < 160°.

Bien entendu, la combinaison d'au moins deux des quatre réalisations mentionnées ci-avant est envisageable.

Dans un mode de réalisation particulièrement préféré, α1 et α2 sont sensiblement égaux et/ou β1 et β2 sont sensiblement égaux.

Par ailleurs, la largeur (11) de la rainure longitudinale peut être d'au plus 1 mm, et de préférence d'au moins 200 µm.

La largeur (l1) est l'écart (la distance) entre les bords des deux portions sensiblement rectilignes inclinées affleurant la face du ruban de carbone.

La largeur (l2) de la partie longitudinale de l'extrémité longitudinale peut être d'au moins 50 µm. En d'autres termes, cette largeur est l'écart (Ia distance) séparant la rainure longitudinale de l'extrémité longitudinale. De préférence, la largeur (l2) est d'au plus 500 µm, de préférence d'au plus 200 µm.

La profondeur (p) de la rainure longitudinale peut être d'au moins 50 µm, et de préférence d'au plus 70 µm, mais elle dépend bien entendu de l'épaisseur du ruban.

La profondeur (p) est la profondeur maximale de la rainure longitudinale. En d'autre terme, elle correspond à l'écart (la distance) le plus grand entre le fond de la rainure, d'une part, et la partie longitudinale la plus proche de la rainure, au niveau de l'extrémité longitudinale, d'autre part, cet écart étant perpendiculaire au plan de symétrie longitudinale du ruban de carbone.

Un autre objet de l'invention concerne un procédé de mise en forme du ruban de carbone conforme à l'invention, comportant l'étape consistant à former au moins ladite rainure longitudinale dans l'épaisseur du ruban de carbone, cette rainure longitudinale étant ainsi pratiquée dans l'épaisseur donnée (e0) du ruban de carbone. Il est ainsi facile de mettre en oeuvre l'étape de formage en partant ruban de carbone plan composé de deux surfaces planes et continues qui vont subir un formage à ces extrémités sur l'une de ses faces ou sur ses deux faces, pour créer la ou les rainures longitudinales

A titre d'exemple, la ou les rainures longitudinales peuvent être formées par laminage ou par extrusion (à travers une filière) d'un ruban de carbone d'une épaisseur donnée (e0).

Un autre objet de l'invention concerne un procédé pour déposer une couche d'un matériau semi-conducteur sur au moins l'une des (deux) faces (longitudinales) du ruban de carbone conforme à l'invention, caractérisé en ce que le procédé comprend l'étape consistant à :
i. tirer progressivement le ruban de carbone, de préférence vers le haut et sensiblement verticalement, en traversant dans le sens de sa longueur la surface horizontale d'équilibre d'un bain du matériau semi-conducteur fondu, lequel se dépose par mouillage sur ladite face au fur et à mesure du tirage du ruban de carbone.

La vitesse de tirage du ruban de carbone selon l'invention peut jouer également sur l'angle de mouillage du matériau semi-conducteur remplissant la ou les rainures longitudinales. L'homme du métier pourra optimiser la conformation du ou des rainures longitudinales, et notamment la valeur de l'angle α1, par rapport à une vitesse de tirage donnée du ruban de carbone, notamment en prenant en compte que plus la vitesse de tirage est grande, plus le temps de contact entre le matériau semi-conducteur et le ruban de carbone (ou la couche de carbone pyrolytique) est court, plus l'angle de mouillage est grand, et plus l'épaisseur à l'extrémité de la couche de matériau semi-conducteur est importante.

Ledit procédé peut comprendre en outre l'étape consistant à déposer une couche de carbone pyrolytique (ou pyrocarbone) sur ledit ruban de carbone, cette étape étant réalisée préalablement à l'étape i de tirage du ruban, ou en d'autres termes préalablement au dépôt du matériau semi-conducteur sur le ruban de carbone.

En effet, lorsque le matériau semi-conducteur est notamment du silicium, le ruban de carbone peut être avantageusement recouvert d'une couche de carbone pyrolytique sur laquelle est déposée la couche de silicium, évitant ainsi la formation de carbure de silicium entre le silicium et le ruban de carbone.

L'épaisseur du ruban de carbone pyrolytique est classiquement comprise entre 1 et 5 µm.

Afin d'obtenir au moins une plaque de matériau semi-conducteur, le procédé décrit ci-avant peut comprendre en outre, après l'étape i, les étapes consistant à :
ii. optionnellement, découper les extrémités du ou des couches de matériaux semi-conducteur à leur extrémité longitudinale au niveau de leur protubérance, de préférence au laser, et
iii. éliminer le ruban de carbone, le ruban de carbone étant de préférence éliminé par brûlage en chauffant à haute température l'ensemble formé par le ruban de carbone et le ou les couches de matériau semi-conducteur.

Grâce à la présente invention, la couche de matériau semi-conducteur ne casse pas à ses extrémités longitudinales puisque son épaisseur ne diminue pas auxdites extrémités.

Toutefois, afin de garantir une planéité homogène sur toute la surface de la couche de matériau semi-conducteur, il peut être avantageux de réaliser l'étape ii mentionnée ci-avant : cette étape de découpe peut s'effectuer en découpant longitudinalement, au niveau de l'angle β1, les extrémités longitudinales du ou des couches de matériaux semi-conducteur, de préférence ensemble avec le ruban de carbone.

En d'autres termes, la partie éliminée sera donc la distance « l1 + l2 », en coupe transversale : il ne restera ainsi que la partie centrale du ruban de carbone recouverte de la couche de matériau semi-conducteur.

L'étape iii d'élimination du ruban de carbone permet d'obtenir une unique plaque de matériau semi-conducteur si la couche de matériau semi-conducteur a été déposée sur une seule des faces du ruban de carbone, et de préférence permet d'obtenir des plaques de matériau semi-conducteur si la couche de matériau semi-conducteur a été déposée sur les deux faces du ruban de carbone.

D'autres caractéristiques et avantages de la présente invention apparaîtront à la lumière de la description des exemples non limitatifs d'un ruban de carbone selon l'invention fait en référence aux figures annotées.
La figure 1 représente schématiquement le procédé de l'art antérieur permettant d'obtenir un ou deux films de matériaux semi-conducteurs par tirage d'un ruban de carbone dans un bain de matériau semi-conducteur fondu.
La figure 2 illustre une vue en coupe transversale de l'amincissement des couches du matériau semi-conducteur obtenues par le procédé de l'antérieur selon la figure 1.
La figure 3a représente une vue schématique d'un ruban de carbone conforme à l'invention, dont les deux faces sont recouvertes d'une couche d'un matériau semi-conducteur.
La figure 3b représente une vue en coupe transversale du ruban de carbone de la figure 3a.
La figure 3c représente une vue en coupe transversale d'une des extrémités du ruban de carbone de la figure 3a.
La figure 4a représente schématiquement le procédé de formage par laminage d'un ruban de carbone selon l'invention.
La figure 4b représente schématiquement le procédé de formage par extrusion à travers une filière d'un ruban de carbone selon l'invention.

Pour des raisons de clarté, les mêmes éléments ont été désignés par des références identiques. De même, seuls les éléments essentiels pour la compréhension de l'invention ont été représentés de manière schématique, et ceci sans respect de l'échelle.

Les figures 1 à 2 ont déjà été décrites précédemment, et pour faciliter la compréhension, les éléments communs entre la présente invention et l'art antérieur portent les mêmes références.

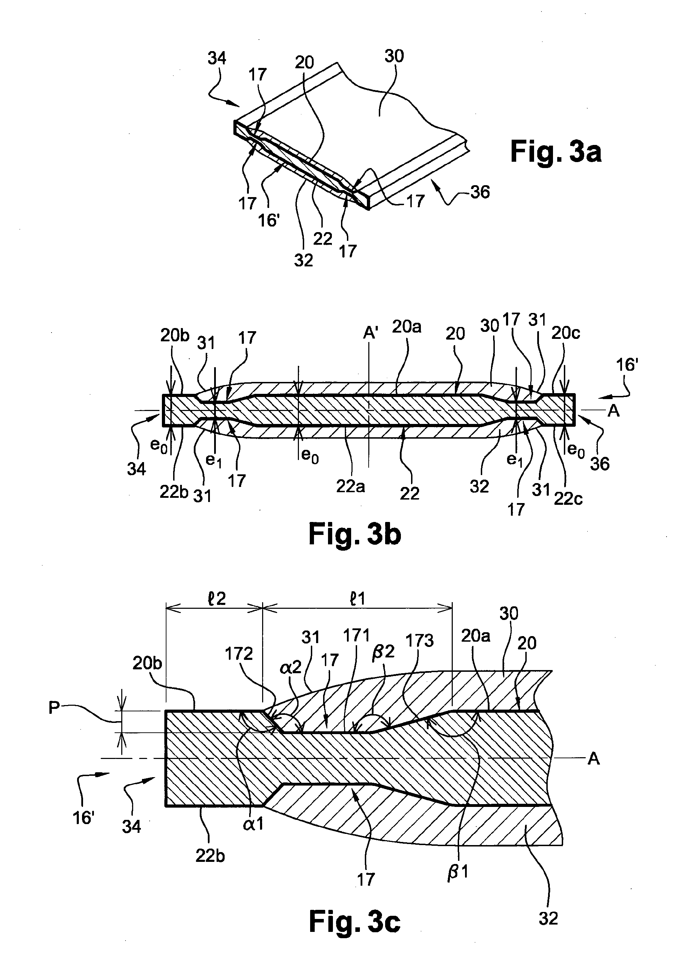

La figure 3a représente une vue schématique d'un ruban de carbone 16' conforme à l'invention, dont les deux faces (longitudinales) 20 et 22 sont respectivement recouvertes d'une couche 30 et 32 d'un matériau semi-conducteur. Le ruban de carbone 16' comprend en outre deux extrémités longitudinales 34 et 36 non recouvertes d'une couche d'un matériau semi-conducteur.

Sur chacune des faces 20 et 22, positionnées entre les deux extrémités longitudinales 34 et 36, se trouvent deux rainures longitudinales 17 conformes à l'invention.

Plus précisément, la figure 3b représente une vue en coupe transversale du ruban de carbone 16' de la figure 3a.

Chaque face 20, 22 du ruban de carbone comporte une partie centrale 20a, 22a située entre les deux extrémités longitudinales 34, 36, cette partie centrale 20a, 22a étant recouverte d'une couche 30, 32 d'un matériau semi-conducteur, contrairement auxdites extrémités 34, 36 qui n'en sont pas recouvertes.

Chaque face 20, 22 comporte en outre deux rainures longitudinales 17 située respectivement entre l'une des extrémités longitudinales 34, 36 et la partie centrale 20a, 22a.

Plus particulièrement, chaque extrémité 34, 36 comporte deux parties longitudinales 20b, 22b et 20c, 22c, ces parties longitudinales n'étant pas recouverte par une couche d'un matériau semi-conducteur.

Sur chaque face 20 ou 22, la partie centrale 20a ou 22a, et les parties longitudinales 20b,20c ou 22b,22c respectivement, sont alignées (en coupe transversale).

Plus généralement, les parties longitudinales 20b, 20c de la face 20 (ou les parties longitudinales 22b, 22c de la face 22) et la partie centrale 20a (ou la partie centrale 22a) sont dans un même plan.

L'épaisseur e0 de tout le ruban de carbone 16', hormis au niveau des rainures 17, ou en d'autres termes l'épaisseur des extrémités longitudinales 34 et 36 (i.e. distance entre la partie longitudinale 20b et la partie longitudinale 22b, ou distance entre la partie longitudinale 20c et la partie longitudinale 22c) et l'épaisseur entre les parties centrales 20a, 22a de chaque face, est supérieure à l'épaisseur e1 du ruban de carbone au niveau du ou des rainures longitudinales 17.

La figure 3 illustre de façon schématique que le matériau semi-conducteur 30, 32 remplit les rainures 17 de chacune des faces 20, 22, formant ainsi une protubérance 31 (i.e. une partie en saillie) adjacente aux extrémités longitudinale 34, 36 du ruban de carbone, et plus particulièrement adjacente à la partie longitudinale 20b, 22b, 20c, 22c la plus proche de la rainure considérée.

Cela signifie que l'épaisseur du ruban de carbone de l'invention est sensiblement identique sur toute sa longueur, notamment au niveau de ses extrémités longitudinales et au niveau de ses parties centrales, excepté au niveau du ou des rainures longitudinales.

Pour des raisons de facilité de mise en forme du ruban de carbone, en coupe transversale, les deux rainures 17 d'une des faces 20 du ruban de carbone sont symétriques aux deux rainures 17 de l'autre face 22 du ruban de carbone, par rapport à l'axe longitudinal A (dans la largeur du ruban de carbone) parallèle aux deux faces du ruban de carbone 16' (l'axe longitudinal A peut également faire référence au plan de symétrie longitudinal du ruban de carbone).

De même, en coupe transversale, les rainures 17 de chaque face 20, 22 proche d'une des extrémités longitudinales 34 sont symétriques aux rainures 17 de chaque face 20, 22 proche de l'autre extrémité longitudinale 36, par rapport à un axe A' médian passant par le milieu du ruban de carbone et perpendiculaire à l'axe A.

La figure 3c représente une vue en coupe transversale de l'extrémité gauche 34 du ruban de carbone 16' de la figure 3a.

Les caractéristiques décrites dans la figure 3c de la rainure 17 de la surface 20 peuvent s'appliquer également à toutes les rainures de la couche de ruban de carbone 16'.

Cette rainure longitudinale 17 est composée d'une portion sensiblement rectiligne 171 formant le fond de la rainure 17. Cette portion sensiblement rectiligne 171 est reliée et délimitée par deux portions sensiblement rectilignes inclinées 172 et 173, formant respectivement des arêtes.

La portion sensiblement rectiligne inclinée 172 est reliée directement à la partie longitudinale 20b formant une arête et la portion sensiblement rectiligne inclinée 173 est reliée directement à la partie centrale 20a formant une arête.

Les zones de liaisons entre la partie longitudinale 20b et la portion sensiblement rectiligne inclinée 172, entre la portion sensiblement rectiligne inclinée 172 et la portion sensiblement rectiligne 171 formant le fond de la rainure, entre la portion sensiblement rectiligne 171 formant le fond de la rainure et la portion sensiblement rectiligne inclinée 173, et entre la portion sensiblement rectiligne inclinée 173 et la partie centrale peuvent également être des zones courbes (non représentées sur les figures).

Dans la figure 3c, la portion sensiblement rectiligne 171 formant le fond de la rainure 17 est sensiblement parallèle à la face 20 du ruban de carbone 16'.

L'angle α1, formé entre la partie longitudinale 20b et la portion sensiblement rectiligne inclinée 172 (portion la plus proche de l'extrémité longitudinale 20b), est de l'ordre de 135°.

L'angle β1, formé entre la partie centrale 20a et la portion sensiblement rectiligne inclinée 173 (portion la plus proche de la partie centrale 20a), est de l'ordre de 150°.

L'angle α2, formé entre la portion sensiblement rectiligne inclinée 172 la plus proche de l'extrémité longitudinale 20b et la portion rectiligne 171 formant le fond de la rainure, est de l'ordre de 135°.

L'angle β2, formé entre la portion sensiblement rectiligne inclinée 173 la plus proche de la partie centrale 20b et la portion rectiligne 171 formant le fond de la rainure, est de l'ordre de 150°.

Par ailleurs, la largeur l1 de la rainure longitudinale peut être de l'ordre de 200µm. Cette largeur l1 est la distance la plus grande, parallèle à l'axe A, séparant les deux portions sensiblement rectilignes inclinées 172 et 173 l'une de l'autre.

La largeur l2 de la partie longitudinale 20b peut être de l'ordre de 100µm. Cette largeur l2 est la distance séparant la rainure longitudinale de l'extrémité longitudinale.

En coupe transversale, lorsqu'au niveau d'une extrémité, deux rainures 17 se trouvent en regard l'une de l'autre par rapport à l'axe de symétrie A, l'épaisseur e1 restante du ruban de carbone doit être suffisante pour maintenir le maintien mécanique dudit ruban. L'épaisseur e1 minimum pour avoir une tenue mécanique suffisante est de préférence d'au moins 100µm.

A titre d'exemple, l'épaisseur e0 du ruban de carbone 16' est égale à 250 µm, l'épaisseur e1 au niveau des deux rainures 17 de l'extrémité 34 est de 150 µm, et la profondeur p pour chaque rainure est donc de 50 µm.

Par ailleurs, pour garantir la planéité du matériau semi-conducteur 30,32 destiné à la fabrication de cellules photovoltaïques, la partie « l1 + l2 » telle que représentée sur la figure 3c en coupe transversale peut être éliminée par découpe laser. La découpe de partie « l1 + l2 » s'effectue dans toute l'épaisseur du ou des couches de matériau semi-conducteur 30, 32 ensemble avec le ruban de carbone 16', au niveau de l'angle β1. Il ne restera donc que les parties centrales 20a et 22a du ruban de carbone recouverte du matériau semi-conducteur.

Une fois la ou les parties « l1 + l2 » découpée(s) à l'une ou aux extrémités longitudinales de la couche de matériau semi-conducteur, le ruban de carbone peut être éliminé par brûlage.

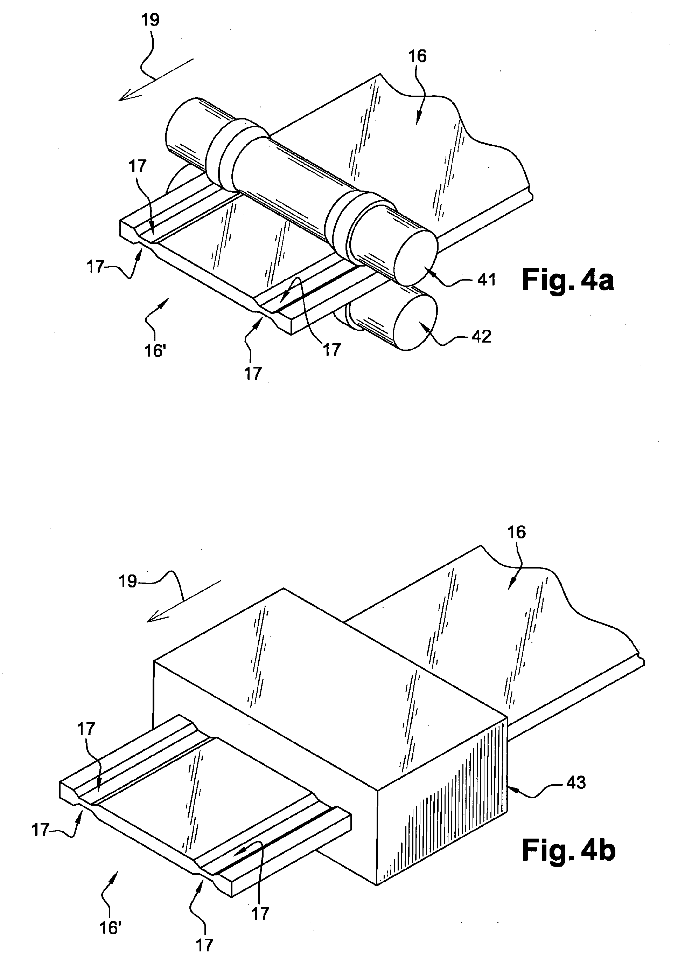

La figure 4a représente schématiquement le procédé de formage par laminage d'un ruban de carbone selon l'invention.

Le ruban de carbone 16' selon l'invention peut être obtenu à partir d'un ruban de carbone 16 dont les deux faces sont sensiblement planes et parallèles, ce ruban de carbone 16 étant mis en forme par laminage (le sens du procédé est défini par le sens de la flèche 19) en passant entre deux rouleaux 41 et 42 dont les surfaces comportent un relief permettant de réaliser la forme des rainures 17 en comprimant le ruban de carbone : la ou les rainures ainsi formées sont de forme complémentaire aux reliefs.

Selon une application particulière (non représentée) destinée à former une ou deux rainures sur uniquement l'une des faces du ruban de carbone 16, un premier rouleau peut comporter un ou deux reliefs tels que mentionnés ci-avant afin de former une ou deux rainures selon l'invention, et le second rouleau peut ne comporter aucun relief.

La figure 4b représente schématiquement le procédé de formage par extrusion à travers une filière d'un ruban de carbone selon l'invention.

Le ruban de carbone 16' selon l'invention peut également être obtenu à partir d'un ruban de carbone 16 dont les deux faces sont sensiblement planes et parallèles, ce ruban de carbone 16 étant mise en forme par extrusion (le sens du procédé est défini par le sens de la flèche 19) en passant par une filière 43 permettant de réaliser la forme des rainures 17 en comprimant le ruban de carbone.

Le nombre de rainures du ruban de carbone 16', ainsi que la forme de la ou des rainures selon l'invention n'est nullement limités aux exemples détaillés sur les figures 3a, 3b, 3c, 4a, et 4d. En effet, le ruban de carbone 16' comprend au moins une rainure conforme à l'invention, et de préférence comprend uniquement deux rainures sur une de ses faces, et de façon particulièrement préférée comprend uniquement deux rainures sur chacune de ses faces.

L'invention apporte une solution techniquement simple et bon marché au problème de la diminution, sur les extrémités longitudinales, de l'épaisseur des couches de semi-conducteur obtenues par tirage d'un ruban de carbone. On améliore ainsi le rendement d'utilisation de la surface du ruban et de la surface de semi-conducteur.

## Revendications

1. Ruban de carbone (16') comportant deux faces (20, 22) et deux extrémités longitudinales (34, 36), au moins l'une des faces du ruban (16') comprenant une partie centrale (20a, 22a) située entre les deux extrémités longitudinales (34, 36) et destinée à recevoir le dépôt d'une couche d'un matériau semi-conducteur (30, 32), **caractérisé en ce qu'**il comporte en outre, sur au moins l'une de ses faces (20, 22), au moins une rainure longitudinale (17) située entre l'une desdites extrémités (34, 36) et la partie centrale (20a, 22a), et **en ce que** la rainure longitudinale (17) est conformée de sorte que, lorsque la couche dudit matériau semi-conducteur est déposée, le matériau semi-conducteur (30, 32) remplissant ladite rainure (17) forme une protubérance (31) adjacente à l'une des extrémités longitudinales (34, 36) de l'une des faces (20, 22) du ruban de carbone.

2. Ruban de carbone selon la revendication 1, **caractérisé en ce que** ladite rainure longitudinale est composée d'une portion (171) formant le fond de la rainure entourée par deux portions sensiblement rectilignes inclinées (172, 173) par rapport à la face (20, 22) du ruban de carbone comprenant ladite rainure.

3. Ruban de carbone selon la revendication 1 ou 2, **caractérisé en ce qu'**il comporte, sur au moins l'une de ses faces (20, 22), deux rainures longitudinales (17) situées entre les deux extrémités longitudinales (34, 36) du ruban.

4. Ruban de carbone selon l'une quelconque des revendications précédentes, **caractérisé en ce qu'**il comporte, sur chacune de ses faces (20, 22), deux rainures longitudinales (17) situées entre les deux extrémités longitudinales (34, 36) du ruban.

5. Ruban de carbone selon l'une quelconque des revendications précédentes, **caractérisé en ce que** chacune des faces (20, 22) du ruban de carbone comporte une partie longitudinale (20b, 20c, 22b, 22c) au niveau de chaque extrémité longitudinale (34, 36), cette partie longitudinale n'étant pas destinée à recevoir le dépôt d'une couche d'un matériau semi-conducteur.

6. Ruban de carbone selon la revendication 5, **caractérisé en ce que** les deux portions rectilignes inclinées (172, 173) de la rainure longitudinale sont reliées respectivement à l'une des parties longitudinales (20b, 20c, 22b, 22c) et à la partie centrale (20a, 22a) par des zones courbes.

7. Ruban de carbone selon l'une quelconque des revendications précédentes, **caractérisé en ce que** les deux portions rectilignes inclinées (172, 173) de la rainure longitudinale sont reliées à la portion rectiligne (171) formant le fond de la rainure par des zones courbes.

8. Ruban de carbone selon l'une quelconque des revendications précédentes, **caractérisé en ce que** la portion rectiligne (171) formant le fond de la rainure est sensiblement parallèle à l'une des faces (20, 22) du ruban de carbone.

9. Ruban de carbone selon l'une quelconque des revendications 5 à 8, **caractérisé en ce que**, en section transversale, l'angle α1, formé entre la partie longitudinale (20b, 20c ; 22b, 22c) et la portion sensiblement rectiligne inclinée (172) la plus proche de l'extrémité longitudinale (34, 36), est défini tel que 90°< α1 < 180°, de préférence tel que 120° < α1 < 160°.

10. Ruban de carbone selon l'une quelconque des revendications 5 à 9, **caractérisé en ce que**, en section transversale, l'angle β1, formé entre la partie centrale (20a, 22a) du ruban et la portion sensiblement rectiligne inclinée (173) la plus proche de la partie centrale (20a, 22a), est défini tel que 90° < β1 < 180°, de préférence 120° < β1 < 160°.

11. Ruban de carbone selon l'une quelconque des revendications précédentes, **caractérisé en ce que** la largeur (l1) de la rainure (17) est d'au plus 1 mm.

12. ruban de carbone selon l'une quelconque des revendications précédentes, **caractérisé en ce que** la largeur (12) de la partie longitudinale (20b, 20, 22b, 22c) de l'extrémité longitudinale est d'au moins 50 µm.

13. ruban de carbone selon l'une quelconque des revendications précédentes, **caractérisé en ce que** la profondeur (p) de la rainure longitudinale est d'au moins 50 µm.

14. procédé de mise en forme du ruban de carbone tel que défini aux revendications 1 à 13, comportant l'étape consistant à former au moins ladite rainure longitudinale dans l'épaisseur du ruban de carbone.

15. Procédé selon la revendication 14, **caractérisé en ce que** ladite rainure est formée par laminage ou par extrusion.

16. procédé pour déposer une couche d'un matériau semi-conducteur sur au moins l'une des faces du ruban de carbone tel que défini aux revendications 1 à 13, **caractérisé en ce que** le procédé comprend l'étape consistant à :
i. tirer progressivement le ruban de carbone (16') en traversant dans le sens de sa longueur la surface horizontale d'équilibre d'un bain (12) du matériau semi-conducteur fondu, lequel se dépose par mouillage sur ladite face au fur et à mesure du tirage du ruban de carbone (16').

17. Procédé selon la revendication 16, **caractérisé en ce qu'**il comprend en outre l'étape consistant à déposer une couche de carbone pyrolytique sur ledit ruban (16'), cette étape étant réalisée préalablement à l'étape i de tirage du ruban.

18. Procédé selon la revendication 16 ou 17, **caractérisé en ce qu'**il comprend en outre, après l'étape i, les étapes consistant à :
ii. optionnellement, découper les extrémités du ou des couches de matériaux semi-conducteur (30, 32) à leur extrémité longitudinale au niveau de leur protubérance, et
iii. éliminer le ruban de carbone (16').

## Patentansprüche

1. Kohlenstoffband (16'), das zwei Seiten (20, 22) und zwei Längsenden (34, 36) aufweist, wobei mindestens eine der Seiten des Bands (16') einen zentralen Teil (20a, 22a) umfasst, der sich zwischen den zwei Längsenden (34, 36) befindet und dazu bestimmt ist, die Ablagerung einer Schicht eines Halbleitermaterials aufzunehmen (30, 32), **dadurch gekennzeichnet, dass** es ferner auf mindestens einer seiner Seiten (20, 22) mindestens eine Längsrille (17) aufweist, die sich zwischen einem der Enden (34, 36) und dem zentralen Teil (20a, 22a) befindet, und dass die Längsrille (17) derart ausgebildet ist, dass, wenn die Schicht des Halbleitermaterials abgelagert ist, das Halbleitermaterial (30, 32), das die Rille (17) füllt, eine Wölbung (31) neben einem der Längsenden (34, 36) einer der Seiten (20, 22) des Kohlenstoffbands bildet.

2. Kohlenstoffband nach Anspruch 1, **dadurch gekennzeichnet, dass** sich die Längsrille aus einem Abschnitt (171), der den Boden der Rille bildet, umgeben von zwei etwa geraden, im Verhältnis zu der Seite (20, 22) des Kohlenstoffbands, die die Rille umfasst, geneigten Abschnitten (172, 173) zusammensetzt.

3. Kohlenstoffband nach Anspruch 1 oder 2, **dadurch gekennzeichnet, dass** es auf mindestens einer seiner Seiten (20, 22) zwei Längsrillen (17) aufweist, die sich zwischen den zwei Längsenden (34, 36) des Bands befinden.

4. Kohlenstoffband nach einem der vorangehenden Ansprüche, **dadurch gekennzeichnet, dass** es auf jeder seiner Seiten (20, 22) zwei Längsrillen (17) aufweist, die sich zwischen den zwei Längsenden (34, 36) des Bands befinden.

5. Kohlenstoffband nach einem der vorangehenden Ansprüche, **dadurch gekennzeichnet, dass** jede der Seiten (20, 22) des Kohlenstoffbands einen länglichen Teil (20b, 20c, 22b, 22c) auf Ebene jedes Längsendes (34, 36) aufweist, wobei dieser längliche Teil nicht zur Aufnahme der Ablagerung einer Schicht eines Halbleitermaterials bestimmt ist.

6. Kohlenstoffband nach Anspruch 5, **dadurch gekennzeichnet, dass** die zwei geneigten geraden Abschnitte (172, 173) der Längsrille jeweils mit einem der länglichen Teile (20b, 20c, 22b, 22c) und mit dem zentralen Teil (20a, 22a) durch gekrümmte Zonen verbunden sind.

7. Kohlenstoffband nach einem der vorangehenden Ansprüche, **dadurch gekennzeichnet, dass** die zwei geneigten geraden Abschnitte (172, 173) der Längsrille mit dem geraden Abschnitt (171), der den Boden der Rille bildet, durch gekrümmte Zonen verbunden sind.

8. Kohlenstoffband nach einem der vorangehenden Ansprüche, **dadurch gekennzeichnet, dass** der gerade Abschnitt (171), der den Boden der Rille bildet, zu einer der Seiten (20, 22) des Kohlenstoffbands etwa parallel ist.

9. Kohlenstoffband nach einem der Ansprüche 5 bis 8, **dadurch gekennzeichnet, dass** im Querschnitt der Winkel α1, der zwischen dem länglichen Teil (20b, 20c; 22b, 22c) und dem geneigten, etwa geraden Abschnitt (172), der dem Längsende (34, 36) am nächsten ist, gebildet wird, derart definiert ist, dass 90° < α1 < 180°, vorzugsweise derart, dass 120° < α1 < 160° ist.

10. Kohlenstoffband nach einem der Ansprüche 5 bis 9, **dadurch gekennzeichnet, dass** im Querschnitt der Winkel β1, der zwischen dem zentralen Teil (20a, 22a) des Bands und dem geneigten, etwa geraden Abschnitt (173), der dem zentraler Teil (20a, 22a) am nächsten ist, gebildet wird, derart definiert ist, dass 90° < β1 < 180°, vorzugsweise 120° < β1 < 160°, ist.

11. Kohlenstoffband nach einem der vorangehenden Ansprüche, **dadurch gekennzeichnet, dass** die Breite (11) der Rille (17) höchstens 1 mm ist.

12. Kohlenstoffband nach einem der vorangehenden Ansprüche, **dadurch gekennzeichnet, dass** die Breite (l2) des länglichen Teils (20b, 20, 22b, 22c) des Längsendes mindestens 50 µm beträgt.

13. Kohlenstoffband nach einem der vorangehenden Ansprüche, **dadurch gekennzeichnet, dass** die Tiefe (p) der Längsrille mindestens 50 µm beträgt.

14. Verfahren zur Bildung des Kohlenstoffbands, so wie in den Ansprüchen 1 bis 13 definiert, das den Schritt aufweist, der darin besteht, mindestens die Längsrille in der Dicke des Kohlenstoffbands auszubilden.

15. Verfahren nach Anspruch 14, **dadurch gekennzeichnet, dass** die Rille durch Laminieren oder durch Extrusion gebildet wird.

16. Verfahren zum Ablagern einer Schicht eines Halbleitermaterials auf mindestens einer der Seiten des Kohlenstoffbands, wie in den Ansprüchen 1 bis 13 definiert, **dadurch gekennzeichnet, dass** das Verfahren den Schritt umfasst, der darin besteht:
i. das Kohlenstoffband (16') schrittweise zu ziehen, wobei es in Richtung seiner Länge die horizontale Gleichgewichtsfläche eines Bads (12) des geschmolzenen Halbleitermaterials durchquert, das sich durch Benetzen nach und nach mit dem Ziehen des Kohlenstoffbands (16') auf der Seite ablagert.

17. Verfahren nach Anspruch 16, **dadurch gekennzeichnet, dass** es ferner den Schritt umfasst, der darin besteht, eine Schicht pyrolytischen Kohlenstoffs auf dem Band (16') abzulagern, wobei dieser Schritt vor dem Schritt i des Ziehens des Bands durchgeführt wird.

18. Verfahren nach Anspruch 16 oder 17, **dadurch gekennzeichnet, dass** es ferner nach dem Schritt i die Schritte umfasst, die darin bestehen:
ii. optional die Enden der Schicht(en) eines Halbleitermaterials (30, 32) an ihrem Längsende auf Ebene ihrer Wölbung abzuschneiden, und
iii. das Kohlenstoffband (16') zu entfernen.

## Claims

1. A carbon tape (16') including two faces (20, 22) and two longitudinal ends (34, 36), at least one of the faces of the tape (16') comprising a central part (20a, 22a) situated between the two longitudinal ends (34, 36) and designed to receive the deposition of a layer of a semiconductor material (30, 32), **characterized in that** it further includes, on at least one of its faces (20, 22), at least one longitudinal slot (17) situated between one of said ends (34, 36) and the central part (20a, 22a), and **in that** the longitudinal slot (17) is configured such that, when the layer of said semiconductor material is deposited, the semiconductor material (30, 32) filling said slot (17) forms a protuberance (31) adjacent to one of the longitudinal ends (34, 36) of one of the faces (20, 22) of the carbon tape.

2. The carbon tape according to claim 1, **characterized in that** said longitudinal slot is made up of a portion (171) forming the bottom of the slot surrounded by two substantially rectilinear inclined portions (172, 173) relative to the face (20, 22) of the carbon tape comprising said slot.

3. The carbon tape according to claim 1 or 2, **characterized in that** it includes, on at least one of its faces (20, 22), two longitudinal slots (17) situated between the two longitudinal ends (34, 36) of the tape.

4. The carbon tape according to any one of the preceding claims, **characterized in that** it includes, on each of its faces (20, 22), two longitudinal slots (17) situated between the two longitudinal ends (34, 36) of the tape.

5. The carbon tape according to any one of the preceding claims, **characterized in that** each of the faces (20, 22) of the carbon tape includes a longitudinal part (20b, 20c, 22b, 22c) at each longitudinal end (34, 36), said longitudinal part not being designed to receive deposition of a layer of a semiconductor material.

6. The carbon tape according to claim 5, **characterized in that** the two inclined rectilinear portions (172, 173) of the longitudinal slot are respectively connected to one of the longitudinal parts (20b, 20c, 22b, 22c) and the central part (20a, 22b) by curved zones.

7. The carbon tape according to any one of the preceding claims, **characterized in that** the two inclined rectilinear portions (172, 173) of the longitudinal slots are connected to the rectilinear portion (171) forming the bottom of the slots by curved zones.

8. The carbon tape according to any one of the preceding claims, **characterized in that** the rectilinear portion (171) forming the bottom of the slot is substantially parallel to one of the faces (20, 22) of the carbon tape.

9. The carbon tape according to any one of claims 5 to 8, **characterized in that**, in transverse section, the angle α1, formed between the longitudinal part (20b, 20c; 22b, 22c) and the substantially rectilinear inclined part (172) closest to the longitudinal end (34, 36), is defined such that 90°< α1 < 180°, preferably such that 120° <α1 < 160°.

10. The carbon tape according to any one of claims 5 to 9, **characterized in that**, in transverse section, the angle β1, formed between the central part (20a, 22a) of the tape and the substantially rectilinear inclined portion (173) closest to the central part (20a, 22a), is defined such that 90°< β1 < 180°, preferably 120° < β1 < 160°.

11. The carbon tape according to any one of the preceding claims, **characterized in that** the width (l1) of the slot (17) is no more than 1 mm.

12. The carbon tape according to any one of the preceding claims, **characterized in that** the width (l2) of the longitudinal part (20b, 20, 22b, 22c) of the longitudinal end is at least 50 µm.

13. The carbon tape according to any one of the preceding claims, **characterized in that** the depth (p) of the longitudinal slot is at least 50 µm.

14. A method for shaping the carbon tape as defined in claims 1 to 13, including the step consisting of shaping at least said longitudinal slot in the thickness of the carbon tape.

15. The method according to claim 14, **characterized in that** said slot is formed by rolling or extrusion.

16. A method for depositing a layer of semiconductor material on at least one of the faces of the carbon tape as defined in claims 1 to 13, **characterized in that** the method comprises the following steps:
i. gradually pulling the carbon tape (16') by passing, in the direction of its length, through the horizontal equilibrium surface of a bath (12) of the molten semiconductor material, which is deposited on said face by wetting over the course of the pulling of the carbon tape (16').

17. The method according to claim 16, **characterized in that** it further comprises the step consisting of depositing a layer of pyrolitic carbon on said tape (16'), said step being carried out before step i for pulling the tape.

18. The method according to claim 16 or 17, **characterized in that** it further comprises, after step i, the following steps:
ii. optionally, cutting the ends of the layer(s) of semiconductor materials (30, 32) at their longitudinal end at their protuberance, and
iii. eliminating the carbon tape (16').
